# EUROPEAN PATENT APPLICATION

(11) **EP 4 753 243 A1**
(43) Date of publication of application: **03.06.2026**
(21) Application number: 24861774.8
(22) Date of filing: 12.08.2024
(51) Int. Cl.: H04M 1/02, G06F 1/16

(54) **ELECTRONIC DEVICE**

(30) Priority: 08.09.2023 CN 202311162773
(71) Applicant: Honor Device Co., Ltd., Shenzhen, Guangdong 518040 (CN)
(72) Inventor: MA, Tengfei, Shenzhen, Guangdong 518040 (CN)
(74) Representative: MERH-IP Matias Erny Reichl Hoffmann Patentanwälte PartG mbB
(86) International application number: PCT/CN2024/111395
(87) International publication number: WO 2025/050930

(57) **Abstract**

This application provides an electronic device, including: a display screen, including a first area and a second area; a housing, including a first panel, where the first panel is disposed opposite to the first area of the display screen in a second direction, first space is formed between the first area and the first panel, and the first panel is provided with one or more through holes communicating with the first space; a sealing assembly, disposed between the display screen and the first panel, and configured to seal the first space in a circumferential direction of the first area; and a piezoelectric ceramic component, disposed in the second area of the display screen. The sealing assembly includes a first sealing member and a second sealing member, the first sealing member is configured to be fixedly connected to the first panel and the display screen, the second sealing member is configured to be elastically connected to the first panel and the display screen, the first sealing member is disposed on at least a side edge that is of the first area and that is away from the second area, and the second sealing member is disposed on at least a side edge that is of the first area and that is close to the second area. In this application, not only a sound generation effect of the display screen is good, but also user privacy is protected.

## Description

This application claims priority to Chinese Patent Application No. 202311162773.5, filed with the China National Intellectual Property Administration on September 8, 2023 and entitled "ELECTRONIC DEVICE", which is incorporated herein by reference in its entirety.

### TECHNICAL FIELD

This application relates to the field of electronic technologies, and in particular, to an electronic device.

### BACKGROUND

Generating sound through vibration of a display screen is a sound generation technology applied to an electronic device. Specifically, a piezoelectric ceramic is disposed on an inner surface of the display screen. The piezoelectric ceramic is a device that can convert an electrical signal into a vibration signal. Different electrical signals are applied to the piezoelectric ceramic, so that the piezoelectric ceramic can vibrate at different amplitudes and/or frequencies, thereby driving the display screen to vibrate to generate sound.

Usually, the display screen is assembled on a housing of the electronic device. In some cases, after the display screen is assembled on the housing, it is difficult to achieve a relatively good sound generation effect.

### SUMMARY

Some implementations of this application provide an electronic device, to use a piezoelectric ceramic to drive a display screen to vibrate to generate sound. In a process in which the display screen generates sound, not only a sound generation effect is good, but also user privacy is protected.

According to a first aspect, this application provides an electronic device, including: a display screen, where the display screen extends along a first plane, the display screen includes a first area and a second area that are spaced apart from each other in a first direction, and the first direction is parallel to the first plane; a housing, where the housing includes a first panel, the first panel and the first area of the display screen are disposed opposite to each other in a second direction, the second direction is perpendicular to the first plane, first space is formed between the first area and the first panel, and the first panel is provided with one or more through holes communicating with the first space; a sealing assembly, where the sealing assembly is disposed between the display screen and the first panel, and the sealing assembly surrounds the first area and is configured to seal the first space in a circumferential direction of the first area; and a piezoelectric ceramic component, where the piezoelectric ceramic component is disposed in the second area of the display screen, and is configured to drive the display screen to vibrate to generate sound. The sealing assembly includes a first sealing member and a second sealing member that are disposed in the circumferential direction along the first area, the first sealing member is configured to be fixedly connected to the first panel and the display screen, the second sealing member is configured to be elastically connected to the first panel and the display screen, the first sealing member is disposed on at least a side edge that is of the first area and that is away from the second area, and the second sealing member is disposed on at least a side edge that is of the first area and that is close to the second area.

According to implementations of this application, when vibration of the display screen is transmitted to a position at which the second sealing member is located, the housing does not prevent vibration of the display screen, and vibration of the display screen may continue to propagate forward, so that the display screen has a sufficient vibration area, to ensure a sound generation effect of the display screen. In addition, when vibration of the display screen is transmitted to a position at which the first sealing member is located, because the display screen is fastened to the housing at this position, vibration of the display screen is terminated, thereby limiting the vibration area of the display screen to a specific range, to ensure user privacy.

In some implementations, the first area includes a third side edge and a fourth side edge that are disposed opposite to each other in a third direction, the third direction is parallel to the first plane and perpendicular to the first direction, and the third side edge is aligned with a middle area of the second area in the first direction; and the second sealing member is further disposed on at least one end that is of the third side edge and that is close to the second area.

According to the implementation of this applications, after vibration of the display screen is transmitted to a lower end point (an end point that is on the third side edge and that is close to the second area) on the third side edge, vibration may continue to propagate upward, to expand the vibration area of the display screen.

In some implementations, there is a gap between the first sealing member and the second sealing member in the circumferential direction of the first area; and the sealing assembly further includes a third sealing member, and the third sealing member is configured to fill the gap.

In some implementations, the third sealing member is an elastic adhesive. According to the implementations of this application, a sealing effect of the sealing assembly can be improved.

In some implementations, a thickness of the third sealing member in a free state is greater than a thickness of the first sealing member.

In some implementations, the housing further includes a second panel, the second panel is disposed opposite to the display screen in the second direction, and is spaced apart from the first panel in the first direction; and the electronic device further includes a connecting member, and in the first direction, the connecting member is located on a side that is of the second area and that faces away from the first area, and is configured to be fixedly connected to the display screen and the second panel.

According to the implementations of this application, after vibration of the display screen is transmitted to a position of the connecting member, forward transmission stops, to limit a vibration range of the display screen to a specific area, thereby avoiding sound leakage and protecting user privacy.

In some implementations, the connecting member includes a strip-shaped adhesive extending in a third direction, and/or the connecting member includes a plurality of dot-shaped adhesives spaced apart from each other in the third direction, and the third direction is parallel to the first plane and perpendicular to the first direction.

In some implementations, a surface that is of the second panel and that faces the connecting member is made of a heat insulation material.

In some implementations, one or more through holes are configured to spatially communicate with the first space and an electronic assembly disposed on a side that is of the first panel and that faces away from the display screen.

In some implementations, the electronic assembly includes a front-facing camera assembly or a depth-sensing camera (also referred to as a "TOF camera") of the electronic device.

In some implementations, in the third direction, both the first area and the second area are located at a middle position of the display screen.

In some implementations, the first sealing member includes a back adhesive, and/or the second sealing member includes foam or liquid silicone rubber.

### BRIEF DESCRIPTION OF DRAWINGS

FIG. 1A is a front view of an electronic device according to an embodiment of this application;
FIG. 1B is a cross-sectional view of an electronic device according to an embodiment of this application;
FIG. 2 is an example application scenario of generating sound by a display screen of an electronic device according to an embodiment of this application;
FIG. 3A is an exploded view of an electronic device in some embodiments;
FIG. 3B is a schematic diagram of a display screen of an electronic device in some embodiments;
FIG. 4 is an internal structural diagram of an electronic device in some embodiments;
FIG. 5A is an exploded view of an electronic device according to an embodiment of this application;
FIG. 5B is a front view of an electronic device (a display screen is removed) according to an embodiment of this application;
FIG. 5C is a cross-sectional view of an electronic device according to an embodiment of this application;
FIG. 6 is a schematic diagram of a sound generation effect of an electronic device according to an embodiment of this application; and
FIG. 7 is a schematic diagram of an assembly process of an electronic device according to an embodiment of this application;

### DESCRIPTION OF EMBODIMENTS

The following describes specific implementations of this application in detail with reference to the accompanying drawings.

The embodiments of this application are used to provide an electronic device, to use a piezoelectric ceramic to drive a display screen to generate sound. In a process in which the display screen generates sound, not only a sound generation effect is good, but also user privacy is provided.

In this application, the electronic device may be a mobile phone, a notebook computer, a tablet computer, a large-screen device, a wearable device (for example, a watch, smart glasses, a helmet), an augmented reality (Augmented Reality, AR)/virtual reality (Virtual Reality, VR) device, a personal digital assistant (Personal Digital Assistant, PDA), or the like. This is not limited in this application. A mobile phone is used as an example of an electronic device 100 below.

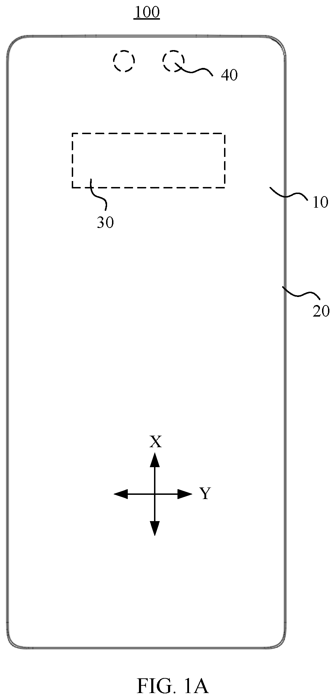

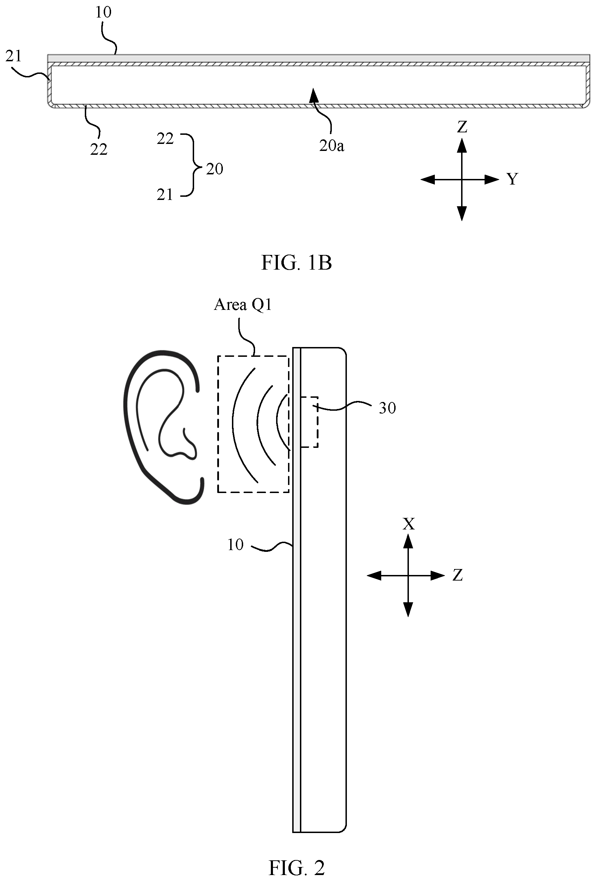

FIG. 1A and FIG. 1B are example structural diagrams of an electronic device 100 according to an embodiment of this application. FIG. 1A is a front view of the electronic device 100. FIG. 1B is a cross-sectional view of the electronic device 100. In the accompanying drawings of this specification, an X direction is a length direction of the electronic device 100, a Y direction is a width direction of the electronic device 100, and a Z direction is a thickness direction of the electronic device 100. The X direction, the Y direction, and the Z direction are perpendicular to each other.

For example, when the electronic device 100 is in a portrait state, the X direction is basically parallel to the vertical direction. When the electronic device 100 is in a landscape state, the X direction is basically parallel to the horizontal direction.

As shown in FIG. 1A and FIG. 1B, the electronic device 100 includes a display screen 10 and a housing 20, and the display screen 10 is disposed on the housing 20. In this embodiment, the housing 20 includes a middle frame 21 and a rear cover 22 (or referred to as a "battery cover"). In a Z direction, the display screen 10 and the rear cover 22 are respectively located on two opposite sides of the middle frame 21. In some other embodiments, the housing 20 may be of an integral structure (in other words, the middle frame 21 and the rear cover 22 are integrated). In addition, an inner cavity 20a is formed inside the housing 20, and various functional devices (not shown), such as a camera module, a speaker module, a communication module, a main board, or a battery, of the electronic device 100 may be disposed in the inner cavity 20a.

The electronic device 100 may implement a display function of the electronic device 100 by using the display screen 10, for example, display a power-on screen, an unlock interface, or an application interface. In some embodiments, the display screen 10 of the electronic device 100 further has a touch function. To be specific, a user may implement input of data, an instruction, and the like by touching the display screen 10.

The display screen 10 may be an organic light-emitting diode (organic light-emitting diode, OLED) display screen, an active-matrix organic light-emitting diode (active-matrix organic light-emitting diode, AMOLED) display screen, or the like. This is not limited in this embodiment.

The electronic device 100 may further implement a sound generation function by using the display screen 10. Specifically, the electronic device 100 further includes a piezoelectric ceramic component 30, and the piezoelectric ceramic component 30 is disposed on an inner surface (a surface that is of the display screen 10 and that faces the inner cavity 20a) of the display screen 10. For ease of observation, FIG. 1A shows a position of the piezoelectric ceramic component 30 on the display screen 10 by using a dotted line. The piezoelectric ceramic component 30 is an apparatus that may convert an electrical signal into a vibration signal. For example, when different voltage signals are applied to the piezoelectric ceramic component 30, the piezoelectric ceramic component 30 may vibrate at different amplitudes and/or frequencies. When the piezoelectric ceramic vibrates, the display screen 10 may be driven to vibrate, so that the display screen 10 generates sound.

FIG. 2 shows an example application scenario in which the display screen 10 generates sound. As shown in FIG. 2, when the user handholds the electronic device 100 for a call, the display screen 10 of the electronic device 100 may be placed close to an ear. In this case, a sound wave emitted by the display screen 10 may be transmitted to a human ear, so that the user clearly hears a call sound. To ensure a call effect, in a call process, it is expected that the sound wave emitted by the display screen 10 may be maintained in a specific area (for example, an area Q1 covered by the human ear). If the sound wave goes beyond this area, sound leakage may occur. In other words, another person around the user may also hear the call sound. If the sound wave is within this area, a propagation range of the sound wave is too small, and the user may be unable to clearly hear a sound emitted by the display screen 10, thereby affecting the call effect.

In addition, to conform to a user habit (for example, when the user is in a handheld call, the user usually handholds a lower middle portion of the electronic device 100, and aligns an upper middle portion of the electronic device 100 with an ear), the piezoelectric ceramic component 30 may be disposed in the upper middle portion of the electronic device 100, and in the Y direction, the piezoelectric ceramic component 30 is located at the center of the electronic device 100. In addition, in this specification, directional nouns such as "upper", "lower", "left", and "right" are based on the portrait state of the electronic device 100. For example, "upper middle portion" indicates an upper middle portion of the electronic device 100 in the portrait state.

It should be noted that FIG. 2 shows, by using the handheld call as an example, the application scenario in which the display screen 10 generates sound. This application is not limited thereto. In another embodiment, generating sound by the display screen 10 may also be applied to another scenario such as voice playing, recording playing, or music playing. In addition, in addition to generating sound by using the display screen 10, the electronic device 100 may generate sound by using another apparatus such as a speaker.

Still as shown in FIG. 1A, the electronic device 100 further includes a front-facing photographing assembly 40 (which is an example of an electronic assembly). The front-facing photographing assembly 40 may include one or more cameras (two cameras are shown in FIG. 1A). The user may implement a self-portrait function by using the front-facing photographing assembly 40. For example, when the user faces the display screen 10, the user may collect an image of the user by using the front-facing photographing assembly 40, and observe a photographing effect on the display screen 10 in real time. To optimize a photographing effect, the front-facing photographing assembly 40 is disposed at a center position of the electronic device 100 in the Y direction.

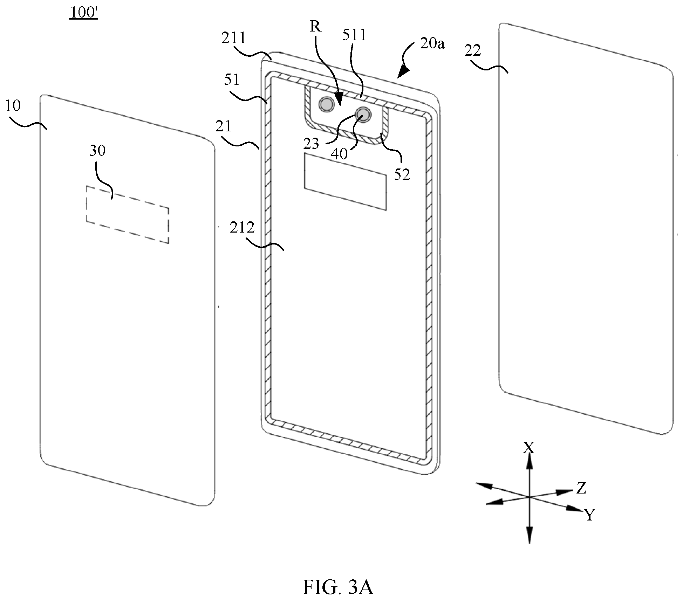

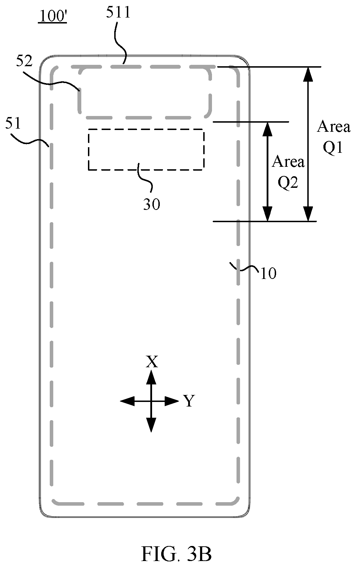

FIG. 3A and FIG. 3B show some installation manners of a display screen 10 and a front-facing photographing assembly 40 in an electronic device 100'. FIG. 3A is an exploded view of the electronic device 100'. FIG. 3B is a front view of the display screen 10.

As shown in FIG. 3A, the electronic device 100' includes the display screen 10, a middle frame 21, and a rear cover 22 that are sequentially disposed in a Z direction. The middle frame 21 includes a side frame 211 and a panel 212, one side (a left side shown in FIG. 3A) of the panel 212 is opposite to the display screen 10, and the other side (a right side shown in FIG. 3A) of the panel 212 is opposite to the rear cover 22. The panel 212, the side frame 211, and the rear cover 22 jointly form an inner cavity 20a of the electronic device 100'.

The display screen 10 is bonded to the panel 212 of the middle frame 21 by using a back adhesive 51, and the front-facing photographing assembly 40 is installed in the inner cavity 20a of the electronic device 100'. The middle frame 21 is provided with several through holes 23. Therefore, external light may enter the front-facing photographing assembly 40 through the through hole 23. As shown in FIG. 3B, space R is formed between the display screen 10 and an area that is on the panel 212 and in which the through hole 23.

To prevent dust, water vapor, and the like from entering the front-facing photographing assembly 40 through the through hole 23, the electronic device 100' further includes a back adhesive 52 (a back adhesive segment 511 is a common segment of the back adhesive 51 and the back adhesive 52) that surrounds the space R in a circumferential direction. The back adhesive 52 is configured to bond the display screen 10 and the panel 212. In this way, the back adhesive 52 may form a sealing strip that seals the space R in the circumferential direction, to prevent dust, water vapor, and the like from entering the front-facing photographing assembly 40 through the through hole 23.

FIG. 3B shows a front view of the display screen 10 (for ease of understanding, FIG. 3B shows positions of the back adhesive 51 and the back adhesive 52 by using thick dotted lines). As shown in FIG. 3B, after the display screen 10 and the panel 212 are bonded by using the back adhesive 52, a position in which the back adhesive 52 is disposed on the display screen 10 is fastened. In this way, when a piezoelectric ceramic component 30 drives the display screen 10 to vibrate to generate sound, vibration is terminated when being transmitted to the position of the back adhesive 52 (in other words, a vibration area of the display screen 10 is Q2). In this way, the vibration area of the display screen 10 is too small (for example, smaller than an area Q1 covered by a human ear), affecting a sound generation effect of the display screen 10, and the user may not hear a sound generated by the display screen 10.

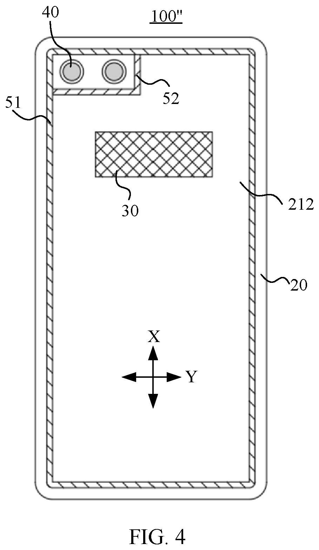

As shown in FIG. 4, in some embodiments, the front-facing photographing assembly 40 may be offset to resolve this problem (for ease of observation, FIG. 4 is a front view of an electronic device 100" from which the display screen 10 is removed). In this embodiment, the front-facing photographing assembly 40 is disposed at a top corner (for example, an upper left corner) of the electronic device 100" instead of a top center of the electronic device 100". In this way, there may be a relatively large distance between the back adhesive 52 and the piezoelectric ceramic component 30, and the display screen 10 may be provided with a sufficient vibration area, thereby ensuring a sound generation effect of the display screen 10.

However, a solution of offsetting the front-facing photographing assembly 40 may affect user experience. For example, when the user directly faces the display screen 10 to take a self-portrait, the front-facing photographing assembly 40 does not directly face the user, but is offset toward one side (for example, a left side) of the user. Therefore, an image photographed by the front-facing photographing assembly 40 is not an image in which the user is located at the center, but an image in which the user is offset on one side. In this case, a self-portrait image seen by the user on the display screen 10 is inconsistent with a directly imagined image, thereby affecting user experience.

In view of this, an embodiment provides an electronic device. In any case in which a photographing assembly is set to be offset (for example, a front-facing photographing assembly is disposed at a top center of the electronic device), a good sound generation effect of a display screen can be achieved. In this embodiment, space R is sealed by using different sealing materials. To be specific, a side that is of the space R and that is away from a piezoelectric ceramic component is sealed by using a first sealing material, and a first sealing member can provide a fixed connection between the display screen and a middle frame (therefore, the first sealing member may also be referred to as a "rigid sealing member"); and a side that is of the space R and that is close to the piezoelectric ceramic component is sealed by using a second sealing member, and the second sealing member can provide an elastic connection between the display screen and the middle frame (therefore, the second sealing member may also be referred to as an "elastic sealing member"). In some embodiments, the rigid sealing member may be a back adhesive, and a flexible sealing member may be foam or liquid silicone rubber.

In this way, when vibration of the display screen is transmitted to a position at which the flexible sealing member is located, the middle frame does not prevent vibration of the display screen, and vibration of the display screen may continue to propagate forward, so that the display screen has a sufficient vibration area, to ensure a sound generation effect of the display screen. In addition, when vibration of the display screen is transmitted to a position at which the rigid sealing member is located, because the display screen is fastened to the middle frame at this position, vibration of the display screen is terminated, to limit the vibration area of the display screen to a specific range, thereby ensuring user privacy.

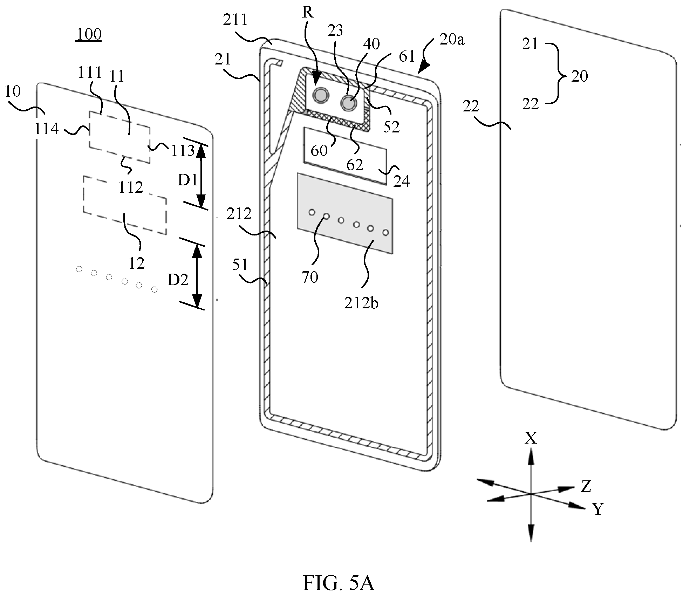

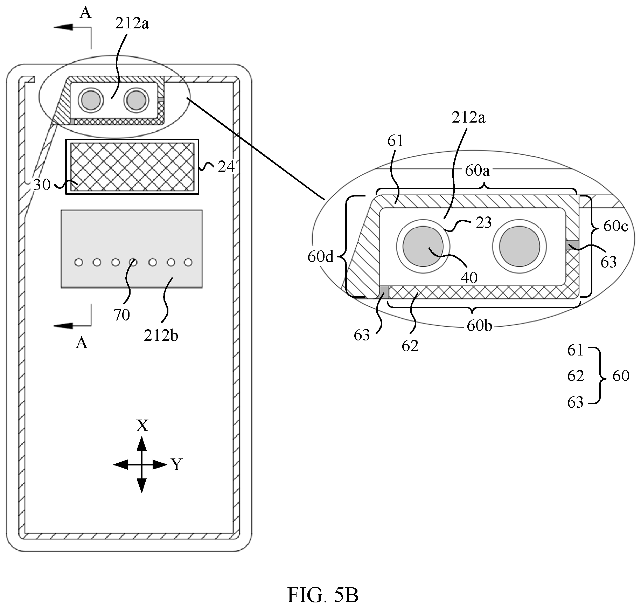

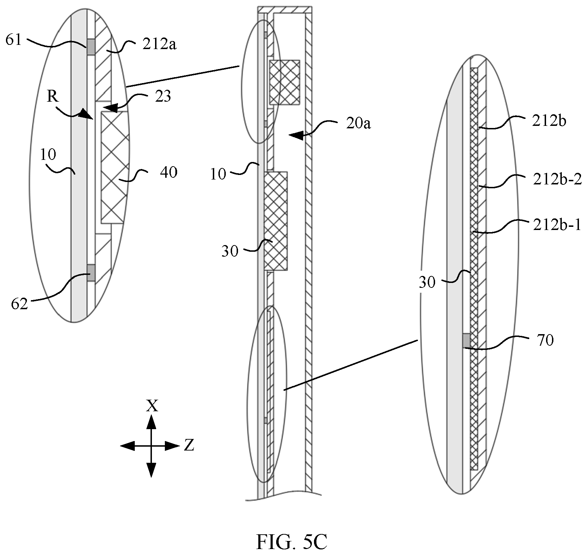

FIG. 5A to FIG. 5C are schematic structural diagrams of an electronic device 100 according to an embodiment. FIG. 5A is an exploded view of the electronic device 100. FIG. 5B is a front view of the electronic device 100 from which a display screen 10 is removed. FIG. 5C is a cross-sectional view of the electronic device 100 (A-A cross-sectional view of FIG. 5B).

As shown in FIG. 5A to FIG. 5C, the electronic device 100 includes the display screen 10, a middle frame 21, and a rear cover 22 that are sequentially connected in a Z direction (which is a second direction). As described above, the middle frame 21 and the rear cover 22 jointly form a housing 20 of the electronic device 100. In another embodiment, the middle frame 21 and the rear cover 22 may be further of an integral structure.

The display screen 10 extends along an X-Y plane (which is a first plane). In some examples, the display screen 10 may be a flat screen, and a plane on which the display screen 10 is located may be parallel to the X-Y plane. In some other examples, the display screen 10 may alternatively be a curved screen, and may have a small radian protrusion or concave relative to the X-Y plane.

The middle frame 21 includes a side frame 211 and a panel 212. The side frame 211 extends in a circumferential direction of the electronic device 100, and may form a side framework of the electronic device 100. Therefore, the side frame 211 may also be understood as a sidewall of the electronic device 100. The panel 212 is disposed on the side frame 211, the panel 212 is disposed opposite to the display screen 10 in the Z direction, and the display screen 10 may be bonded to the panel 212 by using a back adhesive 51. In addition, a side surface of the display screen 10 may also be bonded to the middle frame 21 by using a gap-filling adhesive (not shown), to seal space between the display screen 10 and the middle frame 21. The rear cover 22 is connected to the side frame 211, and the rear cover 22 and the middle frame 21 jointly form an inner cavity 20a of the electronic device 100.

The display screen 10 includes a first area 11 and a second area 12 that are disposed opposite to each other in an X direction (which is an example of a first direction). For ease of understanding, in FIG. 5A, positions at which the first area 11 and the second area 12 are located are outlined by using dotted lines. In the Z direction, the first area 11 is opposite to a front-facing photographing assembly 40 (which is an example of an electronic assembly), and the second area 12 is configured to mount a piezoelectric ceramic component 30. For example, a size of the second area 12 is the same as a size of a mounting surface of the piezoelectric ceramic component 30.

The piezoelectric ceramic component 30 may drive the display screen 10 to vibrate to generate sound. For example, the piezoelectric ceramic component 30 may be bonded to an inner surface of the display screen 10 (the display screen 10 faces a surface of the inner cavity 20a). In addition, a mounting hole 24 may be disposed on the panel 212 of the middle frame 21, and the piezoelectric ceramic component 30 may pass through the mounting hole 24 and extend into the inner cavity 20a of the electronic device 100.

In this application, that A and B are disposed opposite to each other in a direction means that A and B are disposed face to face (face to face) in the direction, and projections of A and B in the direction at least partially overlap each other. On this basis, A and B may be spaced apart from each other in this direction, or may fit each other.

The panel 212 of the middle frame 21 includes a first panel 212a, and the first panel 212a is disposed opposite to the first area 11 of the display screen 10. In some embodiments, the first panel 212a may be understood as a partial area of the panel 212. After the display screen 10 is mounted on the panel 212, there is space R between the first panel 212a and the first area 11 of the display screen 10. The first panel 212a is provided with one or more through holes 23 (two through holes 23 are shown in the figure), and each through hole 23 communicates with the space R. A shape of the through hole 23 is not limited in this embodiment. The through hole 23 may be in any shape such as a circular shape, a square shape, or an irregular shape, provided that the through hole 23 penetrates through the first panel 212a in the Z direction.

The front-facing photographing assembly 40 (which is an example of the electronic assembly) is mounted on a side that is of the through hole 23 and that faces away from the display screen 10. In other words, the through hole 23 may spatially communicate with the space R and the front-facing photographing assembly 40. It may be understood that the front-facing photographing assembly 40 can exchange light with an outside of the electronic device 100 by using the through hole 23. In this embodiment, the front-facing photographing assembly 40 is disposed at a top middle position of the electronic device 100. In another embodiment, the front-facing photographing assembly 40 may also be disposed at another position, for example, an upper left corner or an upper right corner of the electronic device 100.

In this embodiment, the front-facing photographing assembly 40 is used as an example of the electronic assembly. In another embodiment, the electronic assembly may be another assembly, for example, an assembly that needs to exchange light with the outside of the electronic device 100, for example, a depth-sensing camera (also referred to as a "TOF camera"), a flash light, or a breathing light, or an assembly that does not need to exchange light with the outside of the electronic device 100, for example, a motor or a speaker.

In addition, in this embodiment, the electronic assembly and the piezoelectric ceramic component 30 are disposed opposite to each other in the X direction (corresponding to that the first area 11 and the second area 12 of the display screen 10 are disposed opposite to each other in the X direction). That is, in this embodiment, the X direction is used as an example of the first direction. In another embodiment, the first direction may alternatively be another direction parallel to the X-Y plane, for example, a Y direction. That is, in this embodiment, the electronic assembly and the piezoelectric ceramic component 30 are disposed opposite to each other in the Y direction (corresponding to that the first area 11 and the second area 12 of the display screen 10 are disposed opposite to each other in the Y direction).

Still as shown in FIG. 5A and FIG. 5C, because the first panel 212a is provided with the through hole 23, the front-facing photographing assembly 40 and the space R may spatially communicate with each other through the through hole 23. In this way, dust, water vapor, and the like in the inner cavity 20a of the electronic device 100 may enter the front-facing photographing assembly 40, and affect normal use of the front-facing photographing assembly 40.

Therefore, the electronic device 100 further includes a sealing assembly 60, and the sealing assembly 60 is disposed between the display screen 10 and the first panel 212a, is disposed around the first area 11 in a circumferential direction (a circumference direction of the first area 11) of the first area 11, and is configured to seal the space R in the circumferential direction of the first area 11. In this way, the sealing assembly 60 may block the dust and the water vapor in the inner cavity 20a from propagating to the front-facing photographing assembly 40, and protect the front-facing photographing assembly 40.

Specifically, as shown in FIG. 5A, the first area 11 includes four side edges, which are respectively a side edge 111, a side edge 112, a side edge 113, and a side edge 114. The side edge 111 (which is a first side edge) and the side edge 112 (which is a second side edge) are disposed opposite to each other in the X direction, and the side edge 113 (which is a third side edge) and the side edge 114 (which is a fourth side edge) are disposed opposite to each other in the Y direction (which is a third direction). It may be understood that, in the X direction, the side edge 111 is a side edge that is of the first area 11 and that is away from the second area 12, and the side edge 112 is a side edge that is of the first area 11 and that is close to the second area 12.

An extension shape of each side edge of the first area 11 is not limited in this embodiment. Each side edge may be in a straight line shape (for example, the side edge 111 is in a straight line shape), or may be in a curve shape or a broken line shape. Adjacent side edges may be perpendicular to each other (for example, the side edge 111 and the side edge 113 are perpendicular to each other), or may not be perpendicular to each other.

The sealing assembly 60 extends along the side edge 111, the side edge 112, the side edge 113, and the side edge 114, to surround the first area 11 in the circumferential direction. Segments that are of the sealing assembly 601 and that extend along the side edge 111, the side edge 112, the side edge 113, and the side edge 114 are respectively a sealing segment 60a, a sealing segment 60b, a sealing segment 60c, and a sealing segment 60d. It may be understood that an extension shape of each sealing segment is consistent with an extension shape of a corresponding side edge.

In this embodiment, the sealing assembly 60 includes a rigid sealing member 61 (namely, a first sealing member) and an elastic sealing member 62 (namely, a second sealing member) that are sequentially disposed in the circumferential direction of the first area 11, so that the display screen 10 has a good sound generation effect. For ease of observation, the rigid sealing member 61 and the elastic sealing member 62 are shown by using different dashed lines in FIG. 5A and FIG. 5B. As shown in FIG. 5A and FIG. 5B, the rigid sealing member 61 is disposed on at least the side edge 111, and the elastic sealing member 62 is disposed on at least the side edge 112. In other words, the rigid sealing member 61 includes at least the sealing segment 60a, and the elastic sealing member 62 includes at least the sealing segment 60b.

The rigid sealing member 61 is configured to provide a fixed connection between the display screen 10 and the first panel 212a, and the elastic sealing member 62 is configured to provide an elastic connection between the display screen 10 and the first panel 212a. That is, an area that is on the display screen 10 and in which the rigid sealing member 61 is disposed basically has no displacement or can have a very slight displacement (the displacement is denoted as δ1) relative to the first panel 212a, and a position that is on the display screen 10 and at which the elastic sealing member 62 may have a relatively large displacement (the displacement is denoted as δ2) relative to the first panel 212a. The displacement δ2 is far greater than the displacement δ1. For example, the displacement δ2 is more than 5 times of the displacement δ1. For example, the rigid sealing member 61 may be a back adhesive, for example, an acrylic pressure sensitive adhesive, butyl rubber, or a silicone adhesive. The elastic sealing member may be foam or liquid silicone rubber.

It may be understood that, because the sealing segment 60b is configured to provide an elastic connection between the display screen 10 and the first panel 212a, after vibration of the display screen 10 is transmitted to the side edge 112, vibration may continue to be transmitted forward, to expand a sound generation area of the display screen 10, thereby achieving a better sound generation effect. In addition, because the sealing segment 60a is configured to provide a fixed connection between the display screen 10 and the first panel 212a, after vibration of the display screen 10 is transmitted to the side edge 111, vibration stop being transmitted forward, to limit a vibration range of the display screen 10 to a specific area, thereby avoiding sound leakage and protecting user privacy.

A distance D1 between the side edge 112 and the second area 12 may be determined based on a sound generation effect of the display screen 10, for example, determined through a test or simulation. In some embodiments, the distance D1 between the side edge 111 and the second area 12 may be a half of a sound wave area Q1 covered by a human ear, for example, 2 cm~4 cm, when the human ear is close to the display screen 10.

In some embodiments, the side edge 113 is aligned with the middle area of the second area 12 in the X direction. That is, a projection of the side edge 113 in the second area 12 is located in the middle area of the second area 12 in the X direction. The middle area of the second area 12 is located at a center position of the second area 12 in the Y direction, and a ratio of a size of the middle area in the Y direction to a size of the second area 12 in the Y direction is a predetermined value, for example, a value between 0.2~0.6.

In this embodiment, because the side edge 113 is aligned with a middle portion of the second area 12, an elastic sealing material is disposed at an end that is of the sealing segment 60c (a sealing segment disposed on the side edge 113) and that is close to the second area 12. That is, the elastic sealing member 62 is further disposed on an end that is of the side edge 113 and that is close to the second area 12. In this way, after vibration of the display screen 10 is transmitted to a lower end point (an end point that is of the side edge 113 and that is close to the second area 12) of the side edge 113, vibration may further continue to propagate upward, to expand a vibration area of the display screen 10.

As shown in FIG. 5B, because the elastic sealing member 62 and the rigid sealing member 61 are made of different materials, after the elastic sealing member 62 and the rigid sealing member 61 are disposed on the first panel 212a, there may be a gap between the elastic sealing member 62 and the rigid sealing member 61. Therefore, the sealing assembly 60 may further include a third sealing member 63. The third sealing member 63 is configured to fill the gap between the elastic sealing member 62 and the rigid sealing member 61, to ensure that the space R is sealed in the circumferential direction.

In some embodiments, the third sealing member 63 is an elastic adhesive (for example, a damming adhesive). In this way, when the display screen 10 fits the panel 212 of the middle frame 21, the third sealing member 63 may be compressed, thereby improving a sealing effect of the sealing assembly 60. For example, a thickness (a size in the Z direction) of the third sealing member 63 in a free state is greater than a thickness of the first sealing member, to further improve the sealing effect.

Still as shown in FIG. 5A to FIG. 5C, the panel 212 of the middle frame 21 includes a second panel 212b. In some embodiments, the second panel 212b may be understood as another partial area of the panel 212 (different from an area of the first panel 212a). The second panel 212b is disposed opposite to the display screen 10 in the Z direction, and is disposed opposite to the first panel 212a in the X direction. In some embodiments, the second panel 212b is located below the first panel 212a.

To further improve a privacy protection effect of the electronic device 100, the electronic device 100 further includes a connecting member 70. In the X direction, the connecting member 70 is located on a side that is of the second area 12 of the display screen 10 and that faces away from the first area 11, and is configured to be fixedly connected to the display screen 10 and the second panel 212b. That is, at a position at which the connecting member 70 is located, the display screen 10 and the second panel 212b are fixedly connected. In this way, after vibration of the display screen 10 is transmitted to the position of the connecting member 70, vibration stops being transmitted forward, to limit the vibration range of the display screen 10 to the specific area, thereby avoiding sound leakage and protecting user privacy.

In the X direction, a distance D2 between the connecting member 70 and the second area 12 may be determined based on the sound generation effect of the display screen 10, for example, determined through a test or simulation. In some embodiments, the distance D2 between the connecting member 70 and the second area 12 may be a half of the sound wave area Q1 covered by the human ear, for example, 2 cm~4 cm, when the human ear is close to the display screen 10.

In some embodiments, the connecting member 70 is an adhesive (for example, a hot-melt adhesive). For example, the connecting member 70 may be a strip-shaped adhesive extending in the Y direction (which is the third direction), or the connecting member 70 may be a plurality of dot-shaped adhesives spaced apart from each other in the Y direction (as shown in FIG. 5A and FIG. 5B).

As shown in FIG. 5C, a surface that is of the second panel 212b and that faces the connecting member 70 (for example, the hot-melt adhesive) may be made of a heat insulation material 212b-1 (for example, a plastic material). Therefore, heat generated by the hot-melt adhesive may be prevented from diffusing to an outside of the electronic device 100, and a burning sensation of the user when the user holds the electronic device 100 may be avoided. A surface that is of the second panel 212b and that faces away from the connecting member 70 (for example, the hot-melt adhesive) may be made of a metal material 212b-2.

For example, a size of the connecting member 70 in the Y direction may be determined based on the sound generation effect of the display screen 10. In some embodiments, the size of the connecting member 70 in the Y direction may be basically the same as a size of the second area 12 in the Y direction, or may be slightly smaller than the size of the second area 12 in the Y direction, for example, 0.5~0.8 times of the size of the second area 12 in the Y direction.

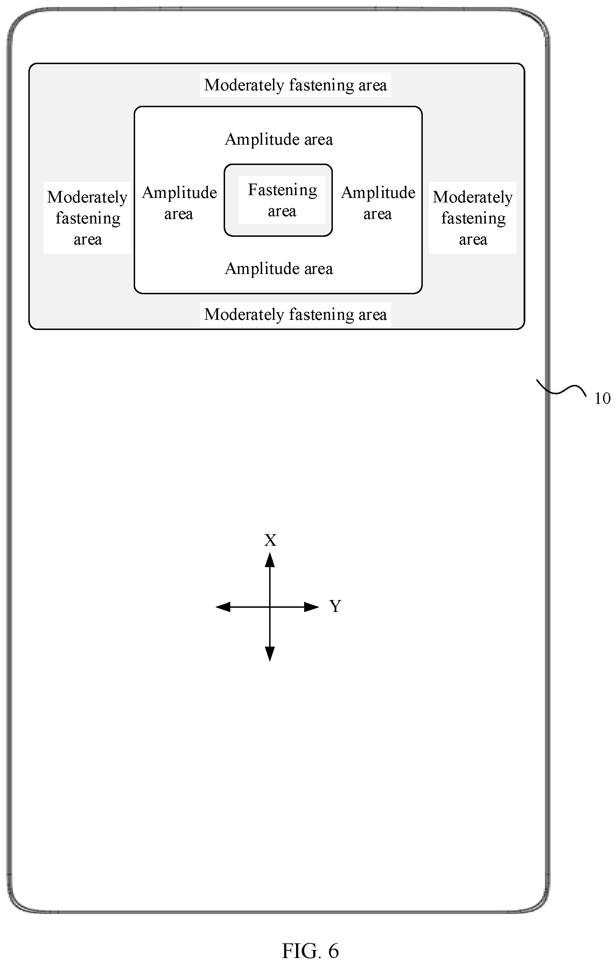

FIG. 6 is a schematic diagram of a sound generation area of the display screen 10 according to an embodiment of this application. As shown in FIG. 6, the display screen 10 includes a fastening area, a moderately fastening area, and an amplitude area. The fastening area may be an area in which the piezoelectric ceramic component 30 fits the display screen 10 (the piezoelectric ceramic component 30 may fit the display screen 10 by using the back adhesive), and the fastening area may be understood as a vibration center when the display screen 10 generates sound.

The moderately fastening area is an area in which the display screen 10 is fixedly connected to the panel 212 of the middle frame 21. For example, a moderately fastening area on an upper side is an area in which the sealing segment 60a of the sealing assembly 60 is disposed, a moderately fastening area on the upper side is an area in which the connecting member 70 is disposed, and moderately fastening areas on two sides, namely, a left side and a right side, are respectively areas in which a left side edge and a right side edge of the back adhesive 51 are disposed. After vibration of the display screen 10 is transmitted to the moderately fastening area, vibration stops being transmitted forward, to limit the vibration range of the display screen 10 to the specific area, thereby avoiding sound leakage and protecting user privacy.

An area between the fastening area and the moderately fastening area is the amplitude area. In the amplitude area, the display screen 10 is basically not constrained by the panel 212 of the middle frame 21, to vibrate at a relatively large amplitude, thereby ensuring the sound generation effect of the display screen 10.

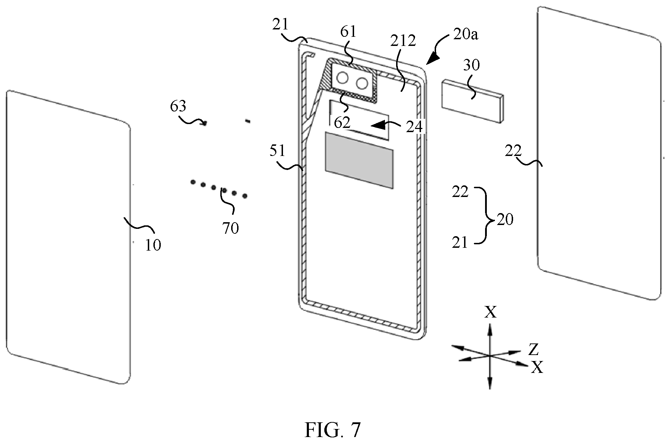

The following describes an example assembly process of the electronic device 100 according to this embodiment of this application. As shown in FIG. 7, when the electronic device 100 is assembled, a middle frame assembly (including the middle frame 21, and the rigid sealing member 61, the elastic sealing member 62, and the back adhesive 51 that are disposed on the panel 212 of the middle frame 21 in advance) is placed in a dispensing fixture, and the gap-filling adhesive (not shown) and the damming adhesive 63 are applied. Then, the display screen 10 is mounted on the middle frame 21, and is fastened by maintaining pressure. Then, the assembled display screen 10 and the middle frame 21 are placed in an automatic assembly device, and the piezoelectric ceramic component 30 passes through the mounting hole 24 on the panel 212 of the middle frame 21 through CCD positioning, and fits the display screen 10, and pressure is maintained. Then, an FPC and a gold finger of the piezoelectric ceramic component 30 are assembled to corresponding positions in the inner cavity 20a of the housing 20. Finally, the front-facing photographing assembly 30, the main board, the battery, and the like are assembled to corresponding positions in the inner cavity 20a of the housing 20, and a rear cover 22 is covered, that is, the electronic device 100 may be assembled.

In the descriptions of the embodiments, unless otherwise specified, "/" means "or". For example, A/B may represent A or B. In this specification, "and/or" is merely an association relationship for describing associated objects, and represents that three relationships may exist. For example, A and/or B may represent the following three cases: Only A exists, only B exists, and both A and B exist.

## Claims

1. An electronic device, comprising:
a display screen, wherein the display screen extends along a first plane, the display screen comprises a first area and a second area that are spaced apart from each other in a first direction, and the first direction is parallel to the first plane;
a housing, wherein the housing comprises a first panel, the first panel and the first area of the display screen are disposed opposite to each other in a second direction, the second direction is perpendicular to the first plane, first space is formed between the first area and the first panel, and the first panel is provided with one or more through holes communicating with the first space;
a sealing assembly, wherein the sealing assembly is disposed between the display screen and the first panel, and the sealing assembly surrounds the first area and is configured to seal the first space in a circumferential direction of the first area; and
a piezoelectric ceramic component, wherein the piezoelectric ceramic component is disposed in the second area of the display screen, and is configured to drive the display screen to vibrate to generate sound, wherein
the sealing assembly comprises a first sealing member and a second sealing member that are sequentially disposed in the circumferential direction of the first area, the first sealing member is configured to be fixedly connected to the first panel and the display screen, the second sealing member is configured to be elastically connected to the first panel and the display screen, the first sealing member is disposed on at least a side edge that is of the first area and that is away from the second area, and the second sealing member is disposed on at least a side edge that is of the first area and that is close to the second area.

2. The electronic device according to claim 1, wherein the first area comprises a third side edge and a fourth side edge that are disposed opposite to each other in a third direction, the third direction is parallel to the first plane and perpendicular to the first direction, and the third side edge is aligned with a middle area of the second area in the first direction; and
the second sealing member is further disposed on at least an end that is of the third side edge and that is close to the second area.

3. The electronic device according to claim 1, wherein there is a gap between the first sealing member and the second sealing member in the circumferential direction of the first area; and
the sealing assembly further comprises a third sealing member, and the third sealing member is configured to fill the gap.

4. The electronic device according to claim 3, wherein the third sealing member is an elastic adhesive.

5. The electronic device according to claim 4, wherein a thickness of the third sealing member in a free state is greater than a thickness of the first sealing member.

6. The electronic device according to claim 1, wherein the housing further comprises a second panel, and the second panel is disposed opposite to the display screen in the second direction and is spaced apart from the first panel in the first direction; and
the electronic device further comprises a connecting member, and in the first direction, the connecting member is located on a side that is of the second area and that faces away from the first area, and is configured to be fixedly connected to the display screen and the second panel.

7. The electronic device according to claim 6, wherein the connecting member comprises a strip-shaped adhesive extending in a third direction, and/or the connecting member comprises a plurality of dot-shaped adhesives spaced apart from each other in the third direction, and the third direction is parallel to the first plane and perpendicular to the first direction.

8. The electronic device according to claim 6, wherein a surface that is of the second panel and that faces the connecting member is made of a heat insulation material.

9. The electronic device according to claim 1, wherein the one or more through holes are configured to spatially communicate with the first space and an electronic assembly disposed on a side that is of the first panel and that faces away from the display screen.

10. The electronic device according to claim 9, wherein the electronic assembly comprises a front-facing camera assembly or a depth-sensing camera of the electronic device.

11. The electronic device according to claim 1, wherein both the first area and the second area are located at a middle position of the display screen in a third direction.

12. The electronic device according to claim 1, wherein the first sealing member comprises a back adhesive, and/or the second sealing member comprises foam or liquid silicone rubber.
